# FASCICULE DE BREVET EUROPEEN

(11) **EP 3 061 141 B1**
(45) Date de publication et mention de la délivrance du brevet: **20.02.2019**
(21) Numéro de dépôt: 14824888.3
(22) Date de dépôt: 23.10.2014
(51) Int. Cl.: H01L 41/00, H01L 41/06, H01L 41/113, H02N 2/18

(54) **GENERATEUR D'ELECTRICITE**
LEISTUNGSGENERATOR
POWER GENERATOR

(30) Priorité: 25.10.2013 FR 1360434
(43) Date de publication de la demande: 31.08.2016
(73) Titulaire: Institut Polytechnique de Grenoble, 38500 Grenoble (FR)
(72) Inventeur: DELAMARE, Jérome, 38000 Grenoble (FR); RICART, Thibault, 38170 Seyssinet Pariset (FR)
(74) Mandataire: Bronchart, Quentin
(86) Numéro de dépôt international: PCT/FR2014/052707
(87) Numéro de publication internationale: WO 2015/059422

(56) Documents cités:
- CN-U- 202 443 031
- US-A- 4 645 961
- US-A1- 2011 057 629
- US-B1- 6 984 902
- XIANZHI DAI ET AL: "Energy harvesting from mechanical vibrations using multiple magnetostrictive/piezoelectric composite transducers", SENSORS AND ACTUATORS A, ELSEVIER SEQUOIA S.A., LAUSANNE, CH, vol. 166, no. 1, 31 décembre 2010 (2010-12-31), pages 94-101, XP028142137, ISSN: 0924-4247, DOI: 10.1016/J.SNA.2010.12.025 [extrait le 2011-01-04]

## Description

L'invention concerne un générateur d'électricité.

Des générateurs connus d'électricité comportent :
- un convertisseur apte à convertir une variation d'un champ magnétique en une différence de potentiels entre deux bornes électriques, ce convertisseur comportant à cet effet :
   - un transducteur électromécanique apte à transformer directement une déformation mécanique exercée sur ce transducteur électromécanique en une différence de potentiels entre les deux bornes électriques, et
   - une couche magnétostrictive s'étendant essentiellement parallèlement à un plan de référence et fixée sans aucun degré de liberté au transducteur électromécanique, cette couche magnétostrictive comportant au moins un bloc en matériau magnétostrictif apte à convertir une variation du champ magnétique en une déformation mécanique exercée sur le transducteur électromécanique,
- une source de champ magnétique comprenant un groupe de plusieurs aimants permanents alignés le long d'un axe d'alignement, au moins l'un du groupe et du convertisseur étant déplaçable, en alternance, entre :
   - une première position dans laquelle les lignes de champ du groupe d'aimants permanents provoquent une première déformation du bloc en matériau magnétostrictif, et
   - une seconde position dans laquelle le bloc en matériau magnétostrictif présente une seconde déformation différente de la première déformation.

De tels générateurs sont par exemples décrits dans la demande US2004/126620A1 ou dans l'article A1 suivant : - T. Lafont, J. Delamare, G. A. Lebedev, D. I. Zakharov, B. Viala, O. Cugat, L. Gimeno, N. Galopin, L. Garbuio et O. Geoffroy, « Magnetostrictive-piezoelectric composite structures for energy harvesting », Journal of michromechanics and microengeneering, n°22, 2012.

Dans les générateurs connus, un unique aimant permanent uni-axial ou un groupe d'aimants permanents est disposé en vis-à-vis de chaque bloc en matériau magnétostrictif. Lorsqu'un groupe d'aimants permanents est utilisé, le pôle sud d'un aimant permanent est directement accolé au pôle nord de l'aimant permanent du même groupe immédiatement consécutif le long de l'axe d'alignement. Autrement dit, les moments magnétiques des aimants permanents de ce groupe sont tous alignés et de même sens. Ainsi, ce groupe d'aimants permanents forme en réalité un unique aimant permanent uni-axial. La section horizontale de l'unique aimant permanent, c'est-à-dire sa section dans un plan parallèle au plan de référence, est sensiblement égale à la section du bloc en matériau magnétostrictif. La longueur L de l'unique aimant permanent dans la direction de son moment magnétique horizontal est donc généralement de plusieurs centimètres. Or pour que cet unique aimant permanent induise à l'intérieur du bloc en matériau magnétostrictif un champ magnétique substantiel, il faut que son rapport de forme soit proche de un. Cela impose donc que l'épaisseur e du gros aimant permanent, dans sa direction verticale, soit environ égale à sa longueur L. Ainsi, la surface de la section verticale de l'unique aimant permanent est proche de L². Cela se traduit par un encombrement important de l'unique aimant permanent et donc du générateur.

De l'état de la technique est également connu de :
- Xinazhi Dai et Al : « Energy harvesting from mechanical vibrations using multiple magnetostrictive/piezoelectric composite transducers », Sensors and actuators A, Elsevier Séquoia S.A, Lausanne CH, vol. 166, N°1, 31/12/2010, pages 94-101 ;
- CN202443031U ;
- US2011/057629A1 ;
- US464596A ;
US6984902B1 .

L'invention vise à diminuer l'encombrement du générateur à efficacité constante ou à encombrement constant à augmenter l'efficacité du générateur. L'efficacité est ici définie comme étant la quantité d'énergie électrique produite par le générateur pour un même déplacement du groupe d'aimants permanents.

Elle a donc pour objet un générateur d'électricité conforme à la revendication 1.

L'utilisation d'une succession de premiers aimants permanents tels que définis ci-dessus permet d'induire simultanément plusieurs champs magnétiques Bᵢ à l'intérieur du même bloc en matériau magnétostrictif dans la première position. Typiquement, ces champs Bᵢ sont alignés les uns après les autres le long d'un axe de déformation du bloc. Chaque champ Bᵢ est de sens opposé au champ Bᵢ₊₁ immédiatement suivant dans la direction de l'axe de déformation. Le bloc en matériau magnétostrictif est uniquement sensible à l'inclinaison du champ Bᵢ par rapport à son axe de déformation et non pas au sens du champ Bᵢ. Ainsi, les deux champs magnétiques Bᵢ et Bᵢ₊₁ provoquent la même contrainte mécanique sur le transducteur électromécanique qu'un seul champ magnétique B_{g} induit par un unique aimant permanent et correspondant à la somme vectorielle du champ Bᵢ et d'un champ B_{i'+1} identique au champ Bᵢ₊₁ mais de sens opposé. Toutefois, dans la première position, pour induire efficacement le champ B_{g} sur une longueur L parallèle à l'axe de déformation de ce bloc en matériau magnétostrictif, cet unique aimant permanent doit avoir une longueur L et une épaisseur proche de cette longueur L et donc une section verticale proche ou supérieure à L². En utilisant les deux premiers aimants permanents pour produire une contrainte proche de celle obtenue avec l'unique aimant permanent, chaque première aimant permanent présente une longueur L/2 et donc une section verticale proche de L²/4. Ainsi, la section verticale du groupe de ces deux premiers aimants permanents est proche de L²/2 (= L²/4 + L²/4). Ainsi, à efficacité égale, une succession de premiers aimants permanents de facteur de forme proche de un permet de réduire l'encombrement de la source de champ magnétique et donc du générateur. On comprend également, que plus le nombre de premier aimants permanents est élevé plus l'encombrement du groupe est réduit. Il est aussi possible de construire la succession de premiers aimants permanents pour que, à encombrement égal, l'efficacité du générateur soit améliorée.

Les modes de réalisation de ce générateur peuvent comporter une ou plusieurs des caractéristiques des revendications dépendantes.

Ces modes de réalisation du générateur présente en outre les avantages suivants :
- l'utilisation de premiers aimants permanents dont les moments magnétiques sont parallèles à l'axe d'alignement permet d'induire, à l'intérieur du bloc en matériau magnétostrictif, un champ magnétique plus important que dans d'autres configurations telles qu'une configuration où les moments magnétiques des premiers aimants permanents sont perpendiculaires à l'axe d'alignement ;
- utiliser des seconds aimants dont les moments magnétiques sont perpendiculaires au plan de référence, ou des dents magnétiques, placés à côté des premiers aimants permanents, permet d'augmenter l'intensité du champ magnétique induit à l'intérieur du bloc en matériau magnétostrictif en dirigeant plus efficacement les champs magnétiques générés ;
- utiliser un second aimant permanent dont l'épaisseur, dans une direction parallèle à l'axe d'alignement, est au moins deux fois plus petite que la longueur du premier aimant permanent à côté duquel il est placé, permet de limiter les dimensions des zones dans le bloc en matériau magnétostrictif où le champ induit est perpendiculaire au plan de référence ;
- configurer les aimants permanents du groupe de sorte que la somme vectorielle des moments magnétiques du groupe soit égale à zéro permet de réduire le couplage magnétique entre ce groupe d'aimants permanents et un champ magnétique extérieur et de limiter la signature magnétique du convertisseur;
- utiliser un second groupe d'aimants permanents symétrique du premier groupe d'aimants permanents limite, voire annule, les efforts exercés par le premier groupe d'aimants permanents sur le bloc en matériau magnétostrictif dans une direction perpendiculaire au plan de référence ;
- utiliser un rapport de forme compris entre 0,2 et 5 permet d'augmenter l'intensité du champ magnétique induit à l'intérieur du bloc en matériau magnétostrictif ;
- la présence d'un autre convertisseur ou d'un plaque en matériau magnétique doux symétrique du premier convertisseur par rapport au groupe d'aimants limite les efforts exercés sur le groupe d'aimants.

L'invention sera mieux comprise à la lecture de la description qui va suivre, donnée uniquement à titre d'exemple non limitatif et faite en se référant aux dessins sur lesquels :
- la figure 1 est une illustration schématique, partiellement en coupe verticale, d'un générateur d'électricité,
- la figure 2 est une illustration schématique, en vue de dessus, d'un convertisseur du générateur de la figure 1,
- la figure 3 est une illustration schématique, en vue de dessus, d'une couche magnétostrictive utilisée dans le convertisseur de la figure 2,
- la figure 4 est une illustration, en vue de dessus, d'une partie d'un ensemble d'aimants permanents utilisé dans le générateur de la figure 1,
- les figures 5 à 8 et 10 sont des illustrations schématiques partielles, en coupe verticale, de différents modes de réalisation d'un groupe d'aimants permanents de l'ensemble de la figure 4 ;
- la figure 9 est une illustration schématique, en vue de dessus, d'un autre mode de réalisation du générateur de la figure 1 dans le cas d'un mouvement en translation ;
- les figures 11 et 12 sont des illustrations schématiques, en coupe verticale, de deux autres modes de réalisation possibles du générateur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

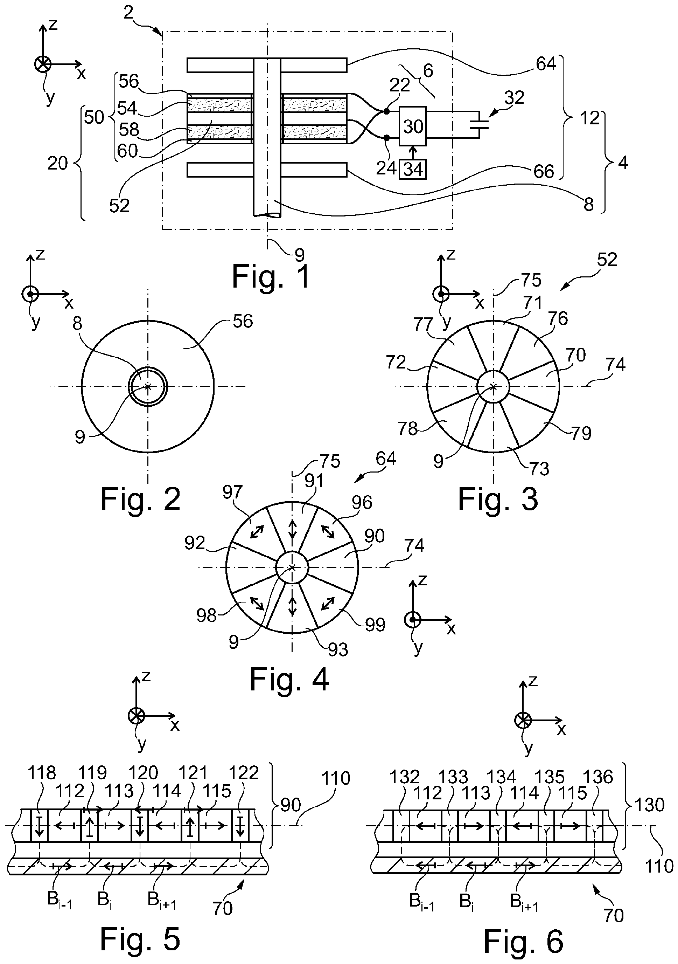

La figure 1 représente un générateur 2 d'électricité. Ce générateur 2 comporte :
- une source 4 de champ magnétique, et
- un récupérateur 6 d'énergie propre à transformer l'énergie à récupérer en énergie électrique.

Ici, le champ magnétique de la source 4 tourne autour d'un axe Z vertical d'un repère orthogonal X, Y, Z. Par la suite, chacune des figures est orientée par rapport à ce repère X, Y, Z.

Dans ce mode de réalisation, la source 4 comporte un ensemble 12 d'aimants permanents fixé sans aucun degré de liberté sur un arbre 8 entraîné en rotation autour d'un axe vertical 9. Par exemple, l'arbre 8 est l'arbre d'un appareil tel qu'un compteur d'électricité ou de gaz entraîné en rotation lors du comptage de l'électricité ou du gaz consommé. Pour simplifier, seul l'arbre 8 de cet appareil est représenté.

Le récupérateur 6 d'énergie comporte :
- un convertisseur 20 qui convertit le champ magnétique tournant en un excédent correspondant de charges électriques sur une borne 22 ou 24 de raccordement par rapport à l'autre de ces bornes 22, 24.
- un circuit 30 de collecte de l'excédent de charges électriques sur la borne 22 ou 24 et de transfert de ces charges électriques collectées vers une élément électrique 32, et
- un circuit 34 de commande du circuit 30 de collecte.

L'élément 32 stocke, consomme et/ou transmet les charges électriques collectées par le circuit 30. A cet effet, l'élément 32 comporte un ou plusieurs composants électriques. Ici, l'élément 32 est un condensateur qui stocke l'énergie électrique récupérée.

Le circuit 30 de collecte et le circuit 34 de commande sont, par exemple, identiques à ceux décrits dans la demande WO 2007/063194 et, de préférence, identiques à l'un de ceux décrits dans la demande déposée sous le n° FR 1260047, le 22 octobre 2012 par le Commissariat à l'énergie atomique et aux énergies alternatives. Par conséquent, ces circuits 30 et 34 ne sont pas décrits ici plus en détail.

Le convertisseur 20 est capable de transformer en électricité des variations très lentes de l'énergie à récupérer. Par « variation lente », on désigne des variations dont la fréquence fondamentale est inférieure à 1 Hz. A cet effet, le convertisseur 20 convertit une variation de l'amplitude du champ magnétique dans une direction donnée en une génération d'un excédent de charges sur la borne 22 et, en alternance, sur la borne 24. Cette conversion se fait presque instantanément de sorte que la tension entre les bornes 22 et 24 varie en même temps et au fur et à mesure que l'amplitude du champ magnétique varie dans une direction donnée.

Dans ce mode de réalisation, le convertisseur 20 est immobile dans le repère XYZ. Plus précisément, il est traversé par l'arbre 8 mais n'est pas entraîné en rotation par cette arbre. Par exemple, il est mécaniquement séparé de l'arbre 8 par un jeu.

Le convertisseur 20 comporte une couche magnétostrictive 52 associée à un transducteur électromécanique 50.

La couche 52 s'étend dans un plan horizontal appelé « plan de référence ». Le plan de référence est situé à mi-hauteur de la couche 52. Elle est réalisée, au moins en partie, dans un matériau magnétostrictif. Ici, par « matériau magnétostrictif », on désigne un matériau dont la valeur absolue maximale du coefficient de magnétostriction λₛ à saturation est supérieure à 10 ppm (partie par million) et, de préférence, supérieure à 100 ou 1000 ppm. Le coefficient λₛ est défini par la relation suivante : λ= ΔL/L, où :
- ΔL est le taux d'élongation du matériau magnétostrictif dans une direction de déformation, et
- L est la longueur de ce matériau dans cette direction en absence de champ magnétique extérieur.

Dans ce mode de réalisation, le coefficient λₛ est positif. Par exemple, le matériau magnétostrictif est le Terfenol-D ou le FeSiB ou un alliage de FeCo. La couche 52 est décrite plus en détail en référence à la figure 3.

Le transducteur électromécanique 50 comprend :
- une couche horizontale supérieure 54 en matériau piézoélectrique,
- une électrode supérieure 56,
- une couche horizontale inférieure 58 en matériau piézoélectrique, et
- une électrode inférieure 60.

La couche 58 et l'électrode 60 sont les symétriques, respectivement, de la couche 54 et de l'électrode 56 par rapport au plan de référence. Par conséquent, cette couche 58 et cette électrode 60 ne sont pas décrites plus en détail.

La couche 54 s'étend horizontalement sur toute la face du dessus de la couche 52. Plus précisément, elle présente une face intérieure collée sans aucun degré de liberté sur cette face du dessus de la couche 52. Cette face intérieure recouvre la majorité et, typiquement, plus de 90 % ou 98 % de la face du dessus de la couche 52. Ici, la couche 54 s'étend uniformément dans chaque direction horizontale. Par exemple, dans ce mode de réalisation, la couche 54 a la forme d'un disque horizontal traversé en son centre par l'arbre 8.

La couche 54 comporte également une face extérieure horizontale située du côté opposé à la face intérieure.

Lors de son fonctionnement, la couche 54 génère un excédent de charges électriques sur la face extérieure quand la couche 52 exerce une contrainte mécanique sur la face intérieure. Ce mode de fonctionnement est connu sous le terme de mode d₃₁. Dans ce mode de fonctionnement, la capacité du transducteur 50 est importante, ce qui améliore et facilite le fonctionnement du convertisseur 20. Typiquement, ce mode de fonctionnement de la couche 52 est obtenu avec un matériau piézoélectrique polarisé verticalement dans le même sens sur toute sa face intérieure.

Ici, le matériau piézoélectrique présente un coefficient de couplage k supérieur à 5 % ou 10 %. Ce coefficient de couplage est défini dans la norme ANSI/IEEE 176-1987 « ANSI/IEEE Standard on Piezoelectricity » ou dans les normes de la famille EN 50-324. Plus précisément, ici, le matériau piézoélectrique utilisé présente un coefficient piézoélectrique g₃₁ supérieur à 5 x 10⁻³Vm/N et, de préférence, supérieur à 10 x 10⁻³Vm/N ou 100 x 10⁻³Vm/N ou 200 x 10⁻³Vm/N à 25° C. Ici, le matériau piézoélectrique est du PZT (Titano-Zyrconate de Plomb) ou du PMN-PT (Plomb Magnésium Niobate / Plomb Titanate).

L'électrode 56 est réalisée dans un matériau électriquement conducteur. Par matériau électriquement conducteur, on désigne un matériau dont la résistivité à 25° C est inférieure à 10⁻⁵ Q.m et, de préférence, inférieure à 10⁻⁶ Q.m ou 10⁻⁷ Ω.m. L'électrode 56 est directement déposée sur la face extérieure de la couche 54. Typiquement, elle recouvre la majorité de cette face extérieure et, de préférence, plus de 70 % ou 80 % de cette face extérieure. Ici, l'électrode 56 est réalisée à l'aide d'une couche d'un seul tenant en matériau électriquement conducteur qui recouvre la majorité de la face extérieure de la couche 54. Plus précisément, dans ce mode de réalisation, l'électrode 56 forme un anneau entourant l'arbre 8 comme visible sur la figure 2.

L'ensemble 12 est fixé sans aucun degré de liberté sur l'arbre 8 de manière à être entraîné en rotation par rapport au convertisseur 20 entre une première et une seconde positions. La première position est représentée sur la figure 4. La seconde position est décalée angulairement de 45° autour de l'axe 9 par rapport à la première position. L'ensemble 12 comporte plusieurs groupes d'aimants permanents uni-axiaux alignés les uns à côtés des autres le long d'un axe d'alignement respectif. Par « uni-axial », on désigne le fait que chaque aimant permanent présente un seul moment magnétique et donc un seul pôle sud et un seul pôle nord. Dans ce mode de réalisation, les groupes d'aimants permanents sont répartis entre une partie supérieure 64 et une partie inférieure 66. La partie inférieure 66 est le symétrique de la partie supérieure 64 par rapport au plan de référence. Ainsi, seule la partie supérieure 64 sera décrite en détail en référence aux figures 4 et 5.

La figure 3 représente plus en détail la structure de la couche 52. La couche 52 est un disque de même rayon que la couche 54. Elle comporte quatre blocs 70 à 73 en matériau magnétostrictif s'étendant le long de deux axes horizontaux 74, 75 se coupant sur l'axe 9. Ici, ces axes 74, 75 s'étendent, respectivement, parallèlement aux directions X et Y. Chaque bloc 70 à 73 est formé d'un seul tenant, c'est-à-dire d'un seul bloc de matière.

Ici, les blocs 70 à 73 sont réalisés dans le même matériau magnétostrictif. De plus, chaque bloc 70 à 73 présente son propre axe préférentiel de déformation. L'axe préférentiel de déformation d'un bloc est l'axe le long duquel l'amplitude de sa déformation est maximale lorsqu'il est traversé par des lignes de champ parallèles à cet axe.

Pour certain matériau mégnétostrictif, lorsque les lignes de champ saturent magnétiquement le bloc magnétostrictif, l'axe préférentiel de déformation est parallèle à ces lignes de champ. Dans cette situation, l'axe préférentiel de déformation est imposé par la disposition du bloc magnétostrictif par rapport à la source de ces lignes de champ. Lorsque le bloc en matériau magnétostrictif n'est pas saturé magnétiquement, l'axe préférentiel de déformation peut aussi être une propriété intrinsèque du bloc qui est due, par exemple, à l'orientation cristalline du matériau magnétostrictif et/ou au facteur de forme du bloc. Ici, par « facteur de forme du bloc», on désigne le rapport de la largeur sur la longueur du rectangle horizontale de plus petite surface à l'intérieur duquel est contenu ce bloc. Typiquement, le facteur de forme de chaque bloc est strictement inférieure à 1 ou 0,5 ou 0,2 et l'axe préférentiel de déformation est ici parallèle à sa longueur. Ainsi, dans les modes de réalisation décrits ci-dessous, à défaut d'indication contraire, l'axe préférentiel de déformation de chaque bloc est systématiquement confondu avec son axe longitudinal. Ici, les axes préférentiels de déformation des blocs 70 et 72 sont alignés sur l'axe 74 et les axes préférentiels de déformation des blocs 71, 73 sont alignés sur l'axe 75.

Le bloc 70 a la forme d'un secteur angulaire dont le sommet est situé sur l'axe 9 et dont la bissectrice est confondue avec l'axe 74. L'angle au sommet du bloc 70 est égal à 45°. Dans ce mode de réalisation, étant donné que la couche 52 est traversée par l'arbre 8, la pointe du secteur angulaire est coupée pour laisser un passage pour l'arbre 8. Les blocs 71 à 73 sont identiques au bloc 70 sauf qu'ils sont décalés angulairement autour de l'axe 9 par rapport au bloc 70 de, respectivement, 90°, 180° et 270°.

Dans ce mode de réalisation, la couche 52 comporte également quatre régions 76 à 79 dépourvues de matériau magnétostrictif et intercalées entre les blocs 70 à 73. Les bords latéraux des blocs 70 à 73 sont donc mécaniquement séparés des bords latéraux des autres blocs immédiatement adjacents par ces quatre régions 76 à 79.

La région 76 est délimitée d'un côté par un bord latéral du bloc 70 et de l'autre côté par un bord latéral du bloc 71. Sa périphérie extérieure est alignée avec un bord vertical des couches 54 et 58. Les régions 77, 78 et 79 sont identiques à la région 76 sauf qu'elles sont décalées angulairement autour de l'axe 9, respectivement, de 90°, 180° et 270°. Ainsi, dans ce mode de réalisation, les régions 76 à 79 sont des secteurs angulaires de même forme que le bloc 70 mais décalées angulairement autour de l'axe 9, respectivement, de 45°, 135°, 225° et 315° par rapport à la position du secteur angulaire du bloc 70. L'épaisseur de chacune de ces régions 76 à 79 est égale à l'épaisseur des blocs 70 à 73.

La figure 4 représente plus en détail la partie supérieure 64 de l'ensemble 12 dans la première position. Sur la figure 4 la direction de l'axe d'alignement de chaque groupe d'aimants permanents est représentée par une double flèche.

Dans ce mode de réalisation, la partie 64 comporte quatre groupes 90 à 93 d'aimants permanents. L'angle entre les axes d'alignement des groupes 90 à 93 est choisi égal à l'angle existant entre les axes préférentielles de déformation des blocs 70 à 73 à plus ou moins 10° près et, de préférence, à plus ou moins 5° près. Ainsi, dans la première position, les axes d'alignement des aimants permanents des groupes 90 et 92 sont parallèles à l'axe 74 à plus ou moins 10° ou 5° près. Au même instant, les axes d'alignement des aimants permanents des groupes 91 et 93 sont parallèles à l'axe 75 à plus ou moins 10° ou 5° près.

Les groupes 90 à 93 ont chacun la même forme, dans un plan horizontal, que les blocs 70 à 73 et sont agencés les uns par rapport aux autres comme décrit pour les blocs 70 à 73. Ainsi, dans la première position, chaque bloc 70 à 73 est en vis-à-vis d'un groupe 90 à 93 respectif.

Par la suite, on dit qu'un bloc est en vis-à-vis d'un groupe d'aimants si la surface de l'intersection entre les projections orthogonales de ce bloc et de ce groupe, sur le plan de référence, est supérieure ou égale à plus de 50 % et, de préférence, à plus de 80 % ou 90 % de la surface de ce bloc dans ce plan. Dans ces conditions, on dit aussi que ce bloc est situé à l'intérieur de la projection orthogonale du groupe d'aimants. Cette même définition est également utilisée pour définir ce que l'on entend par le fait qu'un élément est situé en vis-à-vis d'un groupe d'aimants. Dans la première position, les blocs 70 à 73 sont contenus à l'intérieur des projections orthogonales, respectivement, des groupes 90 à 93.

Dans la première position, les régions 76 à 79 sont situées en dehors des projections orthogonales des groupes 90 à 93. On considère qu'un élément est situé en dehors de la projection orthogonale d'un groupe d'aimants s'il n'est pas situé à l'intérieur de cette projection avec la définition donnée ci-dessus. Lors qu'un élément est en dehors de la projection orthogonale d'un groupe d'aimants on dit également qu'il est dans une position décalée par rapport à ce groupe d'aimants.

Ici, dans la première position, les groupes 90 et 92 sont symétriques l'un de l'autre par rapport à un plan vertical passant par l'axe 75. De façon similaire, au même instant, les groupes 91 et 93 sont symétriques l'un de l'autre par rapport à un plan vertical passant par l'axe 74. Ainsi, seul le groupe 90 sera décrit plus en détail en référence à la figure 5.

En vis-à-vis des régions 76 à 79, dans la première position, la partie 64 comporte des groupes 96 à 99 supplémentaires d'aimants permanents. Chacun de ces groupes 96 à 99 a la même forme que le groupe 90 sauf que ces groupes 96 à 99 sont décalés angulairement autour de l'axe 9 de, respectivement, 45°, 135°, 225° et 315° par rapport à la position du groupe 90. Ainsi, après une rotation de 45° de l'ensemble 12 pour atteindre la seconde position, chaque bloc 70 à 73 se trouve en vis-à-vis d'un groupe 96 à 99 respectif.

Les directions des axes d'alignement des groupes 96 à 99 sont telles que les lignes de champ magnétique qu'ils génèrent à l'intérieur des blocs 70 à 73 dans la seconde position soient tournées de 90°, dans un plan horizontal, par rapport aux lignes de champs magnétique que génèrent les groupes 90 à 93 à l'intérieur de ces mêmes blocs mais dans la première position. Pour cela, l'axe d'alignement de chaque groupe 96 à 99 est perpendiculaire à la bissectrice du secteur angulaire occupé par ce groupe. Le mode de réalisation détaillé de ces groupes 96 à 99 se déduit de celui qui va être décrit pour le groupe 90.

La figure 5 représente plus en détail le groupe 90. Sur la figure 5 et les suivantes, le moment magnétique de chaque aimant permanent est représenté par une flèche.

La figure 5 représente une portion du groupe 90. Pour simplifier cette figure et les suivantes, seul le bloc 70 en vis-à-vis du groupe 90, dans la première position, a été représenté. De même, les lignes de champ générées par le groupe d'aimants permanents sont représentées sur cette figure et les suivantes par des lignes en pointillés.

Les aimants permanents du groupe 90 sont alignés les uns à côté des autres le long d'un axe 110 d'alignement horizontal. Dans la première position, cet axe 110 est parallèle à l'axe 74 et à la direction X. L'axe 110 coupe l'axe 9.

Ici, chaque aimant permanent du groupe 90 est formé d'un seul bloc de matières aimantées. Chaque aimant permanent est uni-axial et présente donc un seul moment magnétique dans une seule direction. Chaque aimant permanent présente donc une seule paire de pôles sud et nord.

Le groupe 90 comporte une succession, le long de l'axe 110, de premiers aimants permanents dont le facteur de forme est proche de un. Par « facteur de forme proche de un », on désigne un facteur de forme supérieur à 1/10 et, de préférence, supérieur à 1/7 ou à 1/5 ou à 1/3 ou à 1/2 et, inférieur à 10, à 7, à 5 ou à 3 ou à 2. Ici, le facteur de forme des premiers aimants permanents est égal à un. Par facteur de forme d'un aimant permanent, on désigne le rapport e/l, où :
- l est la longueur de l'aimant permanent dans la direction de son moment magnétique, et,
- e est l'épaisseur de l'aimant magnétique dans une direction perpendiculaire à celle de son moment magnétique.

Si l'aimant permanent n'a pas une section verticale rectangulaire ou carrée, alors les dimensions l et e définies ci-dessus sont celles du rectangle de plus petite surface contenant la section verticale de cet aimant permanent.

On rappelle également que l'épaisseur est la plus petite dimension parmi les dimensions perpendiculaires à la direction du moment magnétique.

Ici, par convention, on appelle «premier aimant permanent » un aimant permanent du groupe 90 qui présente les deux caractéristiques suivantes :
- son facteur de forme est proche de un, et
- l'essentiel des lignes de champ qui se rebouclent par l'intermédiaire du bloc 70 et de ce premier aimant ne passe pas par un autre premier aimant permanent du groupe 90 ou d'un autre groupe d'aimants.

Le groupe 90 comprend au moins deux premiers aimants permanents et, de préférence, au moins quatre ou dix premiers aimants permanents. Sur la figure 5, seuls quatre premiers aimants permanents 112 à 115 sont représentés.

Les moments magnétiques de ces premiers aimants permanents sont alignés sur l'axe 110. De plus, le moment magnétique d'un quelconque de ces premiers aimants permanents est de sens opposé au premier aimant permanent qui le suit ou le précède immédiatement dans la direction X. Ainsi, les pôles de même polarité de deux premiers aimants permanents successifs sont en vis-à-vis. Ici, les moments magnétiques des aimants 112 et 114 sont dirigés vers la gauche alors que les moments magnétiques des aimants 113 et 115 sont dirigés vers la droite.

Dans ce mode de réalisation, en plus des premiers aimants permanents, le groupe 90 comporte également des seconds aimants permanents destinés à diriger le flux magnétique du groupe 90 vers le bloc 70. Sur la figure 5, cinq seconds aimants permanents 118 à 122 sont représentés. Chaque second aimant permanent est placé entre les pôles de deux premiers aimants permanents consécutifs dans la direction X. Ainsi, le second aimant permanent n'est pas séparé du premier aimant permanent à côté duquel il est immédiatement placé par un autre premier aimant permanent. Ici, chaque second aimant permanent est directement accolé à droite et à gauche, le long de la direction X, à un pôle respectif d'un premier aimant permanent. Les moments magnétiques des seconds aimants permanents sont perpendiculaires au plan de référence et disposés de manière à diriger le flux magnétique des premiers aimants permanents vers le bloc 70. A cet effet, le moment magnétique des seconds aimants permanents accolés de chaque côté à des pôles sud de deux premiers aimants permanents consécutifs est dirigé vers le bloc 70. Sur la figure 5, c'est le cas des seconds aimants permanents 118, 120 et 122. A l'inverse, le moment magnétique des seconds aimants permanents accolés de chaque côté à des pôles nord de deux premiers aimants permanents immédiatement consécutifs est dirigé vers le haut, c'est-à-dire s'éloigne du bloc 70. Sur la figure 5, c'est le cas des seconds aimants permanents 119 et 121.

Les seconds aimants permanents n'ont pas nécessairement un facteur de forme proche de un. Ici, la longueur l des seconds aimants permanents dans la direction Z est égale à l'épaisseur e des premiers aimants permanents. L'épaisseur des seconds aimants permanents dans la direction X est deux ou trois fois plus petite que la longueur des premiers aimants permanents. La dimension des seconds aimants permanents dans la direction Y est comprise entre la dimension dans cette même direction, du premier aimant permanent immédiatement précédent et du premier aimant permanent immédiatement suivant dans la direction X.

A cause de cette disposition des premiers aimants permanents et de leur facteur de forme proche de un, la succession de premiers aimants permanents produit, au même instant, à l'intérieur du bloc 70 une succession de champs magnétiques Bᵢ tous parallèles à l'axe 110 et dont les sens alternent. Les intensités des champs magnétiques induits de cette façon à l'intérieur du bloc 70 sont beaucoup plus grandes que si un seul aimant permanent uni-axial de même dimension que le groupe 90 était utilisé. On rappelle ici que les matériaux magnétostrictifs ne sont pas sensibles au sens du champ magnétique mais uniquement à la direction du champ magnétique induit par rapport à leurs axes préférentiels de déformation. Le mode de réalisation décrit ici exploite cette propriété pour produire, avec un encombrement identique, une contrainte en tension exercée par le bloc 70 sur les couches piézoélectriques 54 et 58 plus importante que si un unique aimant permanent uni-axial était utilisé. Cela accroît donc l'efficacité du générateur à encombrement identique ou, à efficacité égale, permet de décroître l'encombrement de l'ensemble 12.

Les moments magnétiques des premiers aimants permanents sont égaux en amplitude mais de sens opposé deux par deux. Les premiers aimants permanents dont les moments magnétiques sont opposés sont immédiatement disposés l'un après l'autre le long de l'axe 110. Par conséquent, la somme vectorielle des moments magnétiques des aimants permanents du groupe est nulle ou presque nulle. Par « presque nulle », on désigne ici que cette somme vectorielle donne un vecteur dont l'amplitude est égale à zéro à plus ou moins ε près, où ε est égal à 10 %, et de préférence à 5 %, de la somme des amplitudes des moments magnétiques de ce groupe d'aimants. Cela limite le couplage magnétique entre le bloc 90 et un champ magnétique externe uniforme.

Le fonctionnement du générateur 2 est le suivant. Dans la première position, représentée sur la figure 4, les blocs 70 à 73 sont traversés par des lignes de champ parallèles à leur axe préférentiel respectif de déformation. En réponse, la déformation, ici l'allongement, des blocs 70 à 73 est maximale. La couche 52 exerce donc dans cette première position des contraintes maximales en tension sur les couches 54 et 58 en même temps le long des axes 74 et 75. Ainsi, dans les zones de la face extérieure des couches 54 et 58 situées à la verticale des blocs 70 à 73, un excédent de charges électriques de même signe est produit. De plus, étant donné que les couches 54 et 58 sont rigides, les zones des couches 54 et 58 situées à la verticale des régions 76 à 79 sont également soumises à une contrainte en tension de sorte que la face extérieure de ces couches 54 et 58 présentent également des zones, en vis-à-vis des régions 76 à 79, générant un excédent de charges électriques de même signe. Dès lors, dans cette première position, des charges électriques de même signe sont générées sur quasiment la totalité de la face extérieure des couches 54 et 58, ce qui accroît la différence de potentiels produite par le convertisseur 20.

Lorsque le convertisseur 20 fait 1/8 de tour autour de l'axe 9 depuis la première position, la seconde position est atteinte. Dans cette seconde position, les blocs 70 à 73 sont situés à mi-distance entre les groupes 90 à 93 consécutif et en vis-à-vis d'un groupe 96 à 99 respectif. Les régions 76 à 79 sont en vis-à-vis des groupes 90 à 93. Puisque ces régions 76 à 79 sont dépourvues de matériau magnétostrictif, les blocs 70 à 73 ne tendent plus à s'allonger mais, au contraire, ils se rétrécissent simultanément. En effet, les lignes de champs magnétiques qui traversent les blocs 70 à 73 sont maintenant perpendiculaires aux axes longitudinaux de ces blocs. Des lors, chaque bloc 70 à 73 exerce un contrainte en compression sur les couches 54 et 58. Cela permet d'augmenter l'amplitude entre les différences de potentiels produites dans les première et seconde positions.

Les figures qui suivent représentent différentes variantes possibles du groupe 90. Le fonctionnement du générateur 2 avec ces variantes se déduit des explications précédemment données avec le groupe 90.

La figure 6 représente un groupe 130 d'aimants permanents. Ce groupe 130 est identique au groupe 90 sauf que les seconds aimants permanents sont remplacés par des dents magnétiques de mêmes dimensions. Chaque dent magnétique est réalisée dans un matériau magnétique doux. Par matériau magnétique doux, on désigne un matériau magnétique dont le champ magnétique coercitif est inférieur à 100 A.m⁻¹. Par exemple, il s'agit d'un matériau ferromagnétique. Plus précisément, sur la figure 6, les seconds aimants permanents 118 à 122 sont remplacés par des dents magnétiques 132 à 135 de mêmes dimensions que ces seconds aimants.

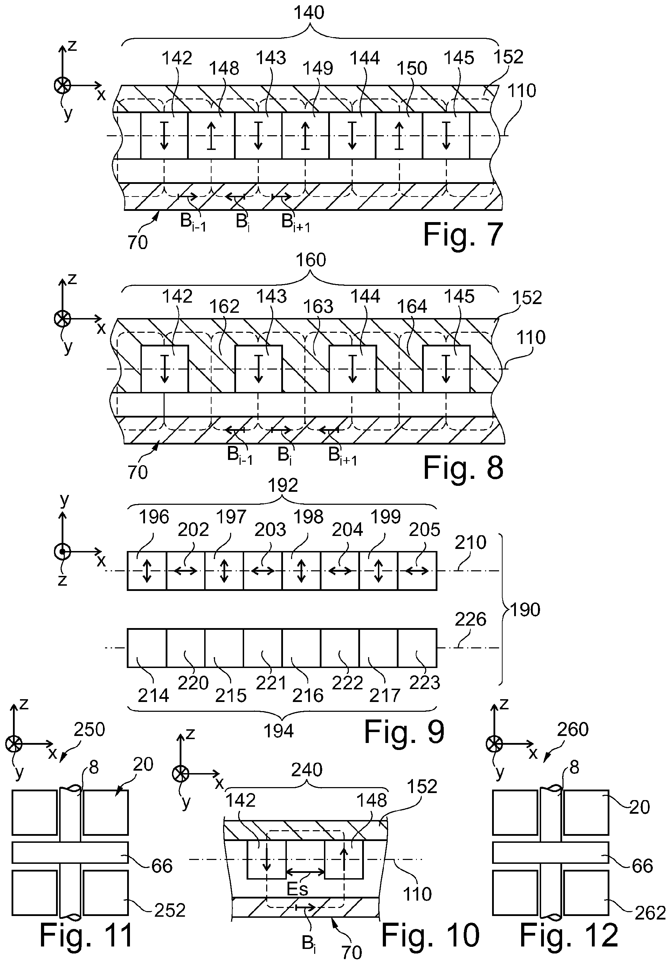

La figure 7 représente un groupe 140 d'aimants permanents. Dans ce mode de réalisation, les premiers aimants permanents sont identiques aux premiers aimants permanents du groupe 90 sauf qu'ils sont tournés pour que leurs moments magnétiques soient perpendiculaires au plan de référence. De plus, les moments magnétiques des premiers aimants permanents sont de même sens. Ici, par convention, on considère que les moments magnétiques des premiers aimants permanents sont dirigés vers le bloc 70. Sur la figure 7, quatre premiers aimants permanents 142 à 147 sont représentés.

Le groupe 140 comporte en plus des seconds aimants permanents pour renforcer et diriger le flux magnétique du groupe vers le bloc 70. Ces seconds aimants permanents sont positionnés comme les seconds aimants permanents du groupe 90. Toutefois, les moments magnétiques de ces seconds aimants permanents sont dirigés verticalement vers le haut, c'est-à-dire en s'éloignant du bloc 70. Trois seconds aimants permanents 148 à 150 sont représentés sur la figure 7.

Dans ce mode de réalisation, les seconds aimants permanents ont également un facteur de forme proche de un. Ici, leur facteur de forme est identique à celui des premiers aimants permanents. Ainsi, pour décrire ce mode de réalisation, une autre convention aurait pu être adoptée consistant à considérer que les premiers aimants permanents ont chacun un moment magnétique dirigé vers le haut. Avec cette autre convention, les aimants permanents décrits précédemment comme les seconds aimants permanents sont des premiers aimants permanents et vice versa.

De préférence, du côté opposé au bloc 70, une plaque magnétique 152 est fixée sans aucun degré de liberté sur les pôles sud et nord des aimants permanents du groupe 140. La plaque 152 est réalisée dans un matériau magnétique doux. Elle permet d'accroître l'intensité du champ magnétique induit par le groupe 140 à l'intérieur du bloc 70 et limite les fuites de champ magnétique du côté opposé au bloc 70.

La figure 8 représente un groupe 160 d'aimants permanents. Ce groupe 160 est identique au groupe 140 sauf que les seconds aimants permanents sont remplacés par des dents magnétiques de mêmes dimensions que les seconds aimants permanents remplacés. Ici, trois dents magnétiques 162 à 164 sont visibles sur la figure 8. De préférence, les dents magnétiques ne forment qu'un seul bloc de matière avec la plaque 152. Ainsi, la combinaison des dents magnétiques et de la plaque 152 forme une culasse magnétique.

Les modes de réalisation décrits jusqu'à présent, l'ont été dans le cas particulier où l'ensemble d'aimants permanents tourne par rapport au convertisseur. Toutefois, tout ce qui a été décrit dans ce contexte particulier, s'applique également au cas où l'ensemble d'aimants permanents se déplace en translation par rapport au convertisseur parallèlement au plan de référence. Pour passer d'un mode de réalisation à l'autre, il suffit de « dérouler » les structures décrites dans le cas d'un mouvement rotatif pour obtenir le mode de réalisation correspondant dans le cas d'un mouvement de translation.

Par exemple, la figure 9 représente un générateur 190 correspondant au mode de réalisation de la figure 1 mais avec un mouvement de translation. Pour simplifier la figure 9, seules les principaux éléments qui diffèrent par rapport au générateur 2 sont représentés. Plus précisément, dans le générateur 190, l'ensemble 12 est remplacé par un ensemble 192 d'aimants permanents et la couche 52 est remplacée par une couche 194. La couche 194 est interposée entre deux couches planes en matériaux piézoélectriques similaires aux couches 54 et 58. Sur la figure 9, l'ensemble 192 et la couche 194 sont représentés en vue de dessus et l'un à côté de l'autre. Dans la réalité, l'ensemble 192 et la couche 194 sont superposés verticalement l'un au-dessus de l'autre.

L'ensemble 192 comprend huit groupes 196 à 199 et 202 à 205 d'aimants permanents. Tous ces groupes d'aimants permanents sont alignés sur un même axe 210 parallèle à la direction X. Les groupes 202 à 204 sont interposés entre, respectivement, les groupes 196, 197, les groupes 197, 198 et les groupes 198, 199. Le groupe 205 est accolé, sur la droite, au groupe 199. Les axes d'alignement des groupes 196 à 199 sont parallèles à la direction Y. Les axes d'alignement des groupes 202 à 205 sont parallèles à la direction X. Ces groupes d'aimants permanents sont réalisés comme décrit précédemment. Tous les groupes ont la même largeur dans la direction X.

La couche 194 comporte quatre blocs 214 à 217 dans le même matériau magnétostrictif séparés par quatre régions 220 à 223 dépourvues de matériau magnétostrictif. Ces blocs et régions sont tous alignés sur un axe 226 parallèle à la direction X. Plus précisément, les régions 220 à 222 sont interposées entre, respectivement, les blocs 214, 215, les blocs 215, 216 et les blocs 216, 217. La région 223 est accolée sur la droite du bloc 217. Cette région 223 peut aussi être omise. Les axes préférentiels de déformation des blocs 214 à 217 sont parallèles à la direction Y.

L'ensemble 192 et la couche 194 sont déplaçables l'un par rapport à l'autre entre une première position, représentée sur la figure 9, et une seconde position. Dans la seconde position, la couche 194 est décalée d'un pas vers la gauche, dans la direction X, par rapport à la première position. Ici, ce pas est égal à la largeur d'un groupe d'aimants de l'ensemble 192.

Dans la première position, les blocs 214 à 217 sont situés en vis-à-vis des groupes 196 à 199 et les régions 220 à 223 sont situées en vis-à-vis des groupes 202 à 205. Dans la seconde position, ce sont les régions 220 à 223 qui sont situées en vis-à-vis des groupes 196 à 199 et les blocs 215 à 217 qui sont situés en vis-à-vis des groupes 202 à 205. Dans cet exemple, dans la seconde position, le bloc 214 n'est en vis-à-vis d'aucun élément. Dans la seconde position, chaque groupe 196 à 198 se trouve à mi-distance entre deux blocs respectifs des blocs 214 à 217.

Dans l'agencement décrit, les groupes 196 à 199 correspondent fonctionnellement aux groupes 90 à 93 et les groupes 202 à 205 correspondent fonctionnellement aux groupes 96 à 99. De même, les blocs 214 à 217 correspondent fonctionnellement aux blocs 70 à 73 et les régions 220 à 223 correspondent fonctionnellement aux régions 76 à 79. Ainsi, le fonctionnement du générateur 190 se déduit du fonctionnement du générateur 2 sauf qu'ici la génération d'électricité est provoquée par un déplacement en translation selon la direction X de la couche 194 par rapport à l'ensemble 192 et non pas par un mouvement de rotation.

La figure 10 représente un groupe 240 d'aimants permanents susceptible d'être utilisé à la place du groupe 90. Ce groupe 240 est identique au groupe 140 sauf que les seconds aimants permanents sont espacés latéralement des premiers aimants permanents par une distance Eₛ mesurée le long de l'axe 110. Par exemple, la distance Eₛ est supérieure ou égale à e/2 ou supérieure ou égale à e, où e est l'épaisseur des premiers aimants permanents.

Avec le groupe 240, la partie horizontale des lignes de champ induites à l'intérieur du bloc 70 par un seul premier aimant permanent est plus longue que dans le mode de réalisation de la figure 7.

La figure 11 représente un générateur 250 identique au générateur 2 sauf que :
- la partie 64 de l'ensemble 12 d'aimants est omise, et
- un convertisseur 252, symétrique du convertisseur 20 par rapport à un plan horizontal, est ajouté.

Le plan de symétrie est un plan médian de la partie 66. Pour simplifier la figure 11 seules les caractéristiques du générateur 250 qui diffèrent de celles du générateur 2 ont été représentées. Ce mode de réalisation permet d'exploiter le champ magnétique présent des deux côtés de la partie 64 pour générer de l'électricité. De plus, ce mode de réalisation permet de rendre symétrique les efforts qui s'exercent sur la partie 66. Cela diminue les efforts qui s'exercent sur la partie 66.

La figure 12 représente un générateur 260 identique au générateur 250 sauf que le convertisseur 252 est remplacé par un disque 262 en matériau magnétique doux. Le disque 262 permet aussi de limiter les efforts qui s'exercent sur la partie 66.

De nombreux autres modes de réalisation sont possibles. Par exemple, l'électrode 56 n'a pas besoin d'être formée d'un seul bloc de matière. En variante, l'électrode 56 comprend plusieurs plots conducteurs répartis sur la face extérieure de la couche 54 et séparés mécaniquement les uns des autres par des tranchées remplies d'un matériau électriquement isolant, des conducteurs électriques raccordant en série ces différents plots.

Dans une autre variante, des électrodes inférieures en matériau électriquement conducteur sont interposées entre la couche 52 et, d'un côté, la couche 54 et de l'autre côté, la couche 60 en matériau piézoélectrique.

La couche piézoélectrique n'est pas non plus nécessairement en un seul bloc. Par exemple, elle peut aussi être réalisée par l'accolement les uns à côté des autres de plusieurs blocs en matériau piézoélectrique. Dans ce cas, tous les blocs de matériau piézoélectrique sont polarisés ou non dans le même sens.

La couche piézoélectrique et les électrodes peuvent aussi être réalisé comme décrit dans l'article suivant :
T. Lafont, J. Delamare, G. A. Lebedev, D. I. Zakharov, B. Viala, O. Cugat, L. Gimeno, N. Galopin, L. Garbuio et O. Geoffroy, « Magnetostrictive-piezoelectric composite structures for energy harvesting », Journal of michromechanics and microengeneering, n°22, 2012;

Dans ce cas, la couche piézoélectrique fonctionne en mode d₃₃.

D'autres matériaux piézoélectrique que le PZT peuvent être utilisés. Par exemple, le matériau piézoélectrique peut être du PVDF (Polyfluorure de Vinylidène) ou une mousse piézoélectrique telle que l'une de celles décrites dans l'article suivant :
Imran Patel, « Ceramic based intelligent piezoelectric energy harversting device », Intechopen, 6 septembre 2011.

L'ordre d'empilement, dans la direction verticale des couches magnétostrictive et piézoélectrique, peut être différent. Par exemple, le convertisseur peut comporter, successivement, dans la direction verticale, une couche magnétostrictive puis une couche piézoélectrique puis une couche magnétostrictive.

La couche en matériau piézoélectrique et la couche magnétostrictive peuvent présenter d'autres formes. Par exemple, avantageusement, elles peuvent également être conformées en forme d'ellipse plutôt que de disque. La section horizontale de ces couches peut également, en variante, être carrée ou rectangulaire ou être un polygone à plus de cinq sommets.

D'autres transducteurs électromécaniques qu'une couche en matériau piézoélectrique peuvent être utilisés. Ainsi, le transducteur électromécanique du convertisseur 20 ne comporte pas nécessairement un matériau piézoélectrique. Par exemple, en variante, le transducteur électromécanique est réalisé à partir d'un condensateur dont la capacité varie en fonction d'un déplacement mécanique. Typiquement, le condensateur comporte deux électrodes mobiles séparées l'une de l'autre par un matériau diélectrique. Lorsque les électrodes se déplacent, la capacité du condensateur varie. Le déplacement des électrodes est actionné par un matériau magnétostrictif pour convertir une variation de champ magnétique en une variation de charges électriques.

Dans un mode particulier de réalisation, les électrodes du condensateur sont réalisées dans un matériau magnétostrictif. Dans ce cas, une variation de l'amplitude du champ magnétique dans une direction donnée entraîne une variation de la surface des électrodes et donc de la capacité de ce condensateur.

Dans une autre variante, on choisit pour le condensateur des électrodes standard et un diélectrique dont la permittivité varie en fonction du champ magnétique. Il peut s'agir par exemple de BiFeO₃. Dans ce cas également, une variation du champ magnétique entraîne une variation de la capacité du condensateur.

La variation de la capacité du condensateur est ensuite transformée en une génération de charges électriques par un dispositif électronique comme, par exemple, un dispositif mettant en oeuvre des électrets. La génération d'électricité à partir d'une variation de capacité et à l'aide d'électrets est par exemple décrite dans l'article suivant :
S. Boisseau, G. Despesse et A. Sylvestre, « Optimization of an electret-based energy harvester », Smart Material and Structures, 2010, 19 075015, IOP Publisching Ltd.

De nombreux autres modes de réalisation de la couche magnétostrictive sont possibles. Par exemple, la forme des blocs 70 à 73 en matériau magnétostrictif peut être modifiée. Ainsi, ces blocs peuvent être rectangulaires de sorte que la réunion des blocs 70 à 73 forme une croix. Dans ce cas, une modification correspondante doit être apportée à la section horizontale des groupes d'aimants permanents en vis-à-vis dans la première position.

En variante, les régions 76 à 79 comportent des blocs en matériau magnétostrictif dont le coefficient de magnétostriction est de signe opposé au coefficient de magnétostriction des blocs 70 à 73. Dans une autre variante, les blocs 76 à 79 comportent chacun un bloc en matériau magnétostrictif dont le coefficient de magnétostriction est de même signe que celui des blocs 70 à 73 mais l'axe préférentiel de déformation est parallèle à l'axe d'alignement d'un groupe 96 à 99 d'aimants permanents dans la première position.

Le nombre de blocs en matériau magnétostrictif et le nombre de groupe d'aimants peut être supérieur à quatre, huit ou douze. En particulier, si le déplacement de l'ensemble est linéaire, le nombre de groupes d'aimants permanents peut être très grand. De préférence, si le déplacement entre les première et seconde positions se fait par rotation, alors le nombre de blocs et de groupes d'aimants est inférieur à douze. Toutefois, si le nombre de blocs de la couche magnétostrictive est par exemple supérieur à douze, alors il est possible de prévoir dans chaque région séparant les différents blocs de la couche magnétostrictive un mécanisme limitant ou éliminant les couplages magnétiques susceptibles d'exister entre ses différents blocs. Le nombre de bloc en matériau magnétostrictif peut aussi être inférieur à quatre. Par exemple, dans le cas le plus simple, la couche 52 comporte un seul bloc de matériau magnétostrictif et, par exemple, un seul groupe d'aimants.

Les différents blocs de la couche magnétostrictive ne s'étendent pas nécessairement dans le même plan. Dans ce cas, le plan de référence est le plan médian aux différents plans dans lesquels s'étendent ces différents blocs.

Si un matériau magnétostrictif à coefficient de magnétostriction négatif est utilisé à la place d'un matériau magnétotrictif à coefficient de magnétostriction positif, dans la première position, le signe des contraintes mécaniques exercées par les blocs est inversé par rapport à ce qui a été décrit dans le cas d'un matériau magnétostrictif à coefficient de magnétostriction positif. Si le coefficient de magnétostriction est négatif, le matériau magnétostrictif peut être du Samfenol, qui est un alliage de Samarium, ou un alliage de cobalt.

Le matériau magnétostrictif utilisé pour réaliser les blocs peut aussi être un matériau magnétostrictif isotrope, c'est-à-dire un matériau qui ne présente pas intrinsèquement d'axe préférentiel de déformation.

En variante les régions entre les blocs en matériau magnétostrictif comportent chacune un bloc supplémentaire de matériau magnétostrictif dont le coefficient de magnétostriction est de signe opposé à celui des blocs 70 à 73 et dont l'axe préférentiel de déformation s'étend radialement. Ainsi, dans la seconde position, les axes préférentiels de déformation des blocs supplémentaires sont alignés avec l'axe d'alignement des groupes 90 à 93. Dès lors, dans la seconde position, les blocs supplémentaires se rétrécissent ce qui exerce des contraintes en compression dans les zones des couches 54 et 58 situées à la verticale de ces blocs supplémentaires. Ainsi, dans cette seconde position, presque la totalité de la surface intérieure des couches 54 et 58 est soumise à une contrainte en compression. Cela permet d'augmenter l'amplitude entre les différences de potentiels produites dans les première et seconde positions par rapport au mode de réalisation de la figure 1 et donc d'augmenter l'efficacité du convertisseur.

Les régions entre les blocs peuvent être omises. Dans ce cas, les bords latéraux d'un bloc sont immédiatement contigus aux bords latéraux de blocs immédiatement adjacents mais dont les axes préférentiels de déformations sont orientés différemment.

De nombreuses variantes de l'ensemble d'aimants permanents sont également possibles. Par exemple, les groupes 96 à 99 peuvent être omis. De même, la partie 66 de l'ensemble d'aimants peut également être omise.

Dans un autre mode de réalisation, les seconds aimants permanents ne sont pas directement accolés aux premiers aimants permanents mais magnétiquement raccordés à ces premiers aimants permanents par l'intermédiaire de noyaux magnétiques réalisés en matériau magnétique doux.

Il est également possible de supprimer les seconds aimants permanents et/ou les dents magnétiques.

Chaque aimant permanent est réalisé dans un seul bloc de matière. En variante, tous les aimants permanents d'un groupe sont réalisés dans un même bloc de matière comportant des zones simultanément aimantées dans différentes directions pour former les premiers et, éventuellement, seconds aimants permanents.

Les aimants permanents de l'ensemble 12 peuvent être disposés dans un plan qui n'est pas nécessairement parallèle au plan de référence. Dans une autre variante, les axes d'alignement des différents groupes de l'ensemble ne sont pas tous coplanaires.

Les directions des axes d'alignement peuvent être modifiées. Par exemple, dans le mode de réalisation de la figure 9, les directions des axes d'alignement de tous les groupes 196 à 199 et 202 à 205 sont tournées de 45° vers la droite. On conserve ainsi un décalage angulaire de 90° entre les axes d'alignement de deux groupes d'aimants immédiatement consécutifs. L'axe préférentiel de déformation des blocs 214 à 217 est alors aussi tourné de 45°. Le fonctionnement de cette variante reste le même que celui décrit en référence à la figure 9. De même, les directions des axes d'alignement des groupes dans les autres modes de réalisation peuvent être modifiées.

Les différents modes de réalisation d'un groupe d'aimants précédemment décrits peuvent être combinés soit au sein d'un même ensemble ou même au sein d'un même groupe.

Le mouvement relatif de l'ensemble 12 par rapport au convertisseur 20 peut également être obtenu en fixant l'ensemble 12 sans aucun degré de liberté et en fixant le convertisseur 20 sur l'arbre 8. D'autre déplacement du convertisseur 20 par rapport à l'ensemble 12 sont possibles. Par exemple, le convertisseur 20 est monté en rotation autour d'un axe horizontal de sorte qu'il se trouve en vis-à-vis de l'ensemble 12 dans une position angulaire donnée et sinon décalé par rapport à l'ensemble 12.

## Revendications

1. Un générateur d'électricité comportant :
- un convertisseur (20) apte à convertir une variation d'un champ magnétique en une différence de potentiels entre deux bornes électriques, ce convertisseur comportant à cet effet :
• un transducteur électromécanique (50) apte à transformer directement une déformation mécanique exercée sur ce transducteur électromécanique en une différence de potentiels entre les deux bornes électriques, et
• une couche magnétostrictive (52) s'étendant essentiellement parallèlement à un plan de référence et fixée sans aucun degré de liberté au transducteur électromécanique, cette couche magnétostrictive comportant au moins un bloc (70-73) en matériau magnétostrictif apte à convertir une variation du champ magnétique en une déformation mécanique exercée sur le transducteur électromécanique,
- une source (4) de champ magnétique comprenant un groupe (90-93, 96-99 ; 130; 140; 160; 196-199, 202-205 ; 240) de plusieurs aimants permanents alignés le long d'un axe d'alignement, au moins l'un du groupe et du convertisseur étant déplaçable, en alternance, entre :
• une première position dans laquelle les lignes de champ du groupe d'aimants permanents traversent le même bloc en matériau magnétostrictif et provoquent une première déformation de ce bloc en matériau magnétostrictif, et
• une seconde position dans laquelle le bloc en matériau magnétostrictif présente une seconde déformation différente de la première déformation,
**caractérisé en ce que** le groupe (90-93, 96-99 ; 130 ; 140 ; 160 ; 196-199, 202-205 ; 240) d'aimants permanents comporte une succession de premiers aimants permanents (112-115 ; 142-145) le long de l'axe d'alignement, un premier aimant permanent étant un aimant permanent du groupe qui présente les deux caractéristiques suivantes :
- un rapport de forme, défini par le rapport de son épaisseur sur sa longueur dans la direction de son moment magnétique, compris entre 1/10 et dix, et
- l'essentiel des lignes de champ qui se rebouclent par l'intermédiaire du bloc en matériau magnétostrictif et de ce premier aimant permanent dans la première position ne passent pas par un autre premier aimant permanent,
ces premiers aimants permanents étant disposés les uns par rapport aux autres de manière à ce que le champ magnétique induit à l'intérieur du bloc en matériau magnétostrictif dans la première position par l'un quelconque de ces premiers aimants permanents soit parallèle et de sens opposé au champ magnétique induit au même instant dans ce même bloc par le premier aimant permanent immédiatement consécutif le long de l'axe d'alignement.

2. Le générateur selon la revendication 1, dans lequel chaque premier aimant permanent (112-115) présente un moment magnétique parallèle à l'axe d'alignement et de sens opposé au sens du moment magnétique du premier aimant permanent immédiatement suivant dans ladite succession de premiers aimants permanents.

3. Le générateur selon la revendication 2, dans lequel le groupe comporte également au moins un second aimant permanent (118-122) placé immédiatement à côté d'un des premiers aimants permanents (112-115), le moment magnétique de ce second aimant permanent étant perpendiculaires au plan de référence et son sens étant le même que celui des lignes de champs qui traversent le bloc en matériau magnétostrictif et le premier aimant permanent à côté duquel il est immédiatement placé.

4. Le générateur selon la revendication 3, dans lequel la longueur du second aimant permanent (118-122) dans la direction de son moment magnétique est supérieure ou égale à l'épaisseur, dans la direction perpendiculaire au plan de référence, du premier aimant permanent à côté duquel il est immédiatement placé, et l'épaisseur du second aimant permanent dans une direction parallèle à l'axe d'alignement est au moins deux fois plus petite que la longueur du premier aimant permanent à côté duquel il est immédiatement placé.

5. Le générateur selon la revendication 2, dans lequel la source de champ magnétique comporte au moins une dent magnétique (132-136), réalisée en matériau magnétique doux, directement placée à côté d'un des premiers aimants permanents dans la direction de l'axe d'alignement.

6. Le générateur selon l'une quelconque des revendications précédentes, dans lequel l'amplitude de la somme vectorielle des moments magnétiques du groupe (90-93, 96-99 ; 130 ; 140 ; 160 ; 196-199, 202-205 ; 240) d'aimants permanents est égale à zéro à plus ou moins ε près, où ε est égal à 10 % de la somme des amplitudes des moments magnétiques des aimants permanents du groupe.

7. Le générateur selon l'une quelconque des revendications précédentes, dans lequel la source de champ magnétique comporte un second groupe d'aimants permanents, symétrique du premier groupe d'aimants permanents par rapport à un plan parallèle au plan de référence et passant à mi-hauteur du bloc en matériau magnétostrictif.

8. Le générateur selon l'une quelconque des revendications 1 à 6, dans lequel le convertisseur se trouve d'un côté du groupe d'aimants permanents et le générateur (250) comporte un autre convertisseur (252) placé du côté opposé par rapport à ce groupe d'aimants permanents, ces deux convertisseurs étant les symétriques l'un de l'autre par rapport à un plan médian du groupe d'aimants permanents contenant l'axe d'alignement de ce groupe.

9. Le générateur selon l'une quelconque des revendications 1 à 6, dans lequel le convertisseur se trouve d'un côté du groupe d'aimants permanents et le générateur comporte une plaque (262) en matériau magnétiquement doux placée du côté opposé par rapport à ce groupe d'aimants permanents.

10. Le générateur selon l'une quelconque des revendications précédentes, dans lequel le rapport de forme des premiers aimants permanents est supérieur ou égal à 0,2 ou à 0,5 et inférieure ou égal à 5 ou 2.

11. Le générateur selon l'une quelconque des revendications précédentes, dans lequel les aimants permanent du groupe sont fixés sans aucun degré de liberté les uns aux autres et au moins l'un du groupe et du convertisseur est déplaçable, en alternance, entre :
- la première position dans laquelle le bloc en matériau magnétostrictif est en vis-à-vis du groupe d'aimants permanents, et
- la seconde position dans laquelle le bloc en matériau magnétostrictif est décalé par rapport au groupe d'aimants permanents.

## Patentansprüche

1. Stromgenerator, umfassend:
- einen Konverter (20), der dazu in der Lage ist, eine Veränderung eines Magnetfeldes in eine Potentialdifferenz zwischen zwei elektrischen Anschlüssen zu konvertieren, wobei dieser Konverter zu diesem Zweck umfasst:
• einen elektromechanischen Wandler (50), der dazu in der Lage ist, eine mechanische Verformung, die auf diesen elektromechanischen Wandler ausgeübt wird, direkt in eine Potentialdifferenz zwischen den zwei elektrischen Anschlüssen umzuwandeln, und
• eine magnetostriktive Schicht (52), die sich im Wesentlichen parallel zu einer Referenzebene erstreckt und ohne jeden Freiheitsgrad am elektromechanischen Wandler befestigt ist, wobei diese magnetostriktive Schicht mindestens einen Block (70-73) aus magnetostriktivem Material umfasst, der dazu in der Lage ist, eine Veränderung des Magnetfeldes in eine mechanische Verformung zu konvertieren, die auf den elektromechanischen Wandler ausgeübt wird,
- eine Magnetfeldquelle (4), die eine Gruppe (90-93, 96-99; 130; 140; 160; 196-199, 202-205; 240) von mehreren Dauermagneten umfasst, welche entlang einer Ausrichtungsachse ausgerichtet sind, wobei mindestens eines aus der Gruppe und dem Konverter wechselweise beweglich ist zwischen:
• einer ersten Stellung, in der die Feldlinien der Gruppe von Dauermagneten durch denselben Block aus magnetostriktivem Material hindurchgehen und eine erste Verformung dieses Blocks aus magnetostriktivem Material bewirken, und
• einer zweiten Stellung, in der der Block aus magnetostriktivem Material eine zweite Verformung aufweist, die sich von der ersten Verformung unterscheidet,
**dadurch gekennzeichnet, dass** die Gruppe (90-93, 96-99; 130; 140; 160; 196-199, 202-205; 240) von Dauermagneten eine Abfolge von ersten Dauermagneten (112-115; 142-145) entlang der Ausrichtungsachse umfasst, wobei ein erster Dauermagnet ein Dauermagnet der Gruppe ist, der die zwei folgenden Kennzeichen aufweist:
- ein Formverhältnis, definiert durch das Verhältnis seiner Dicke zu seiner Länge in der Richtung seines Magnetmoments, im Bereich zwischen 1/10 und zehn, und
- der Großteil der Feldlinien, die mittels des Blocks aus magnetostriktivem Material und dieses ersten Dauermagneten in der ersten Stellung rückgeschleift werden, läuft nicht durch einen weiteren ersten Dauermagneten,
wobei diese ersten Dauermagneten so zueinander angeordnet sind, dass das Magnetfeld, das von einem dieser ersten Dauermagneten im Inneren des Blocks aus magnetostriktivem Material in der ersten Stellung induziert wird, zu dem Magnetfeld parallel und entgegengesetzt ist, das zum gleichen Zeitpunkt in diesem selben Block von dem entlang der Ausrichtungsachse unmittelbar darauffolgenden ersten Dauermagneten induziert wird.

2. Generator nach Anspruch 1, wobei jeder erste Dauermagnet (112-115) ein Magnetmoment aufweist, das zur Ausrichtungsachse parallel und der Richtung des Magnetmoments des ersten Dauermagneten, der in der Abfolge der ersten Dauermagneten unmittelbar folgt, entgegengesetzt ist.

3. Generator nach Anspruch 2, wobei die Gruppe ebenfalls mindestens einen zweiten Dauermagneten (118-122) umfasst, der unmittelbar neben einem der ersten Dauermagneten (112-115) platziert ist, wobei das Magnetmoment dieses zweiten Dauermagneten zur Referenzebene senkrecht ist, und seine Richtung dieselbe ist wie diejenige der Feldlinien, die durch den Block aus magnetostriktivem Material und den ersten Dauermagneten, neben dem er unmittelbar platziert ist, hindurchgehen.

4. Generator nach Anspruch 3, wobei die Länge des zweiten Dauermagneten (118-122) in der Richtung seines Magnetmoments größer oder gleich der Dicke in der zur Referenzebene senkrechten Richtung des ersten Dauermagneten ist, neben dem er unmittelbar platziert ist, und die Dicke des zweiten Dauermagneten in einer zur Ausrichtungsachse parallelen Richtung mindestens um die Hälfte kleiner ist als die Länge des ersten Dauermagneten, neben dem er unmittelbar platziert ist.

5. Generator nach Anspruch 2, wobei die Magnetfeldquelle mindestens eine aus weichmagnetischem Material ausgeführte Magnetzinke (132-136) umfasst, die in der Richtung der Ausrichtungsachse direkt neben einem der ersten Dauermagneten platziert ist.

6. Generator nach einem der vorstehenden Ansprüche, wobei die Amplitude der Vektorsumme der Magnetmomente der Gruppe (90-93, 96-99; 130; 140; 160; 196-199, 202-205; 240) von Dauermagneten bis plus oder minus ε gleich Null ist, wobei ε gleich 10 % der Summe der Amplituden der Magnetmomente der Dauermagnete der Gruppe ist.

7. Generator nach einem der vorstehenden Ansprüche, wobei die Magnetfeldquelle eine zweite Gruppe von Dauermagneten umfasst, die symmetrisch von der ersten Gruppe von Dauermagneten zu einer zur Referenzebene parallele Ebene ist und auf halber Höhe des Blocks aus magnetostriktivem Material verläuft.

8. Generator nach einem der Ansprüche 1 bis 6, wobei sich der Konverter auf einer Seite der Gruppe von Dauermagneten befindet, und der Generator (250) einen weiteren Konverter (252) umfasst, der im Verhältnis zu dieser Gruppe von Dauermagneten auf der gegenüberliegenden Seite platziert ist, wobei diese zwei Konverter im Verhältnis zu einer Mittelebene der Gruppe von Dauermagneten, welche die Ausrichtungsachse dieser Gruppe enthält, die Symmetrischen zueinander sind.

9. Generator nach einem der Ansprüche 1 bis 6, wobei sich der Konverter auf einer Seite der Gruppe von Dauermagneten befindet, und der Generator eine Platte (262) aus weichmagnetischem Material umfasst, die im Verhältnis zu dieser Gruppe von Dauermagneten auf der gegenüberliegenden Seite platziert ist.

10. Generator nach einem der vorstehenden Ansprüche, wobei das Formverhältnis der ersten Dauermagneten größer oder gleich 0,2 oder 0,5 und kleiner oder gleich 5 oder 2 ist.

11. Generator nach einem der vorstehenden Ansprüche, wobei die Dauermagneten der Gruppe ohne jeden Freiheitsgrad aneinander befestigt sind, und mindestens eines aus der Gruppe und dem Konverter wechselweise beweglich ist zwischen:
- der ersten Stellung, in der der Block aus magnetostriktivem Material der Gruppe von Dauermagneten gegenüberliegt, und
- der zweiten Stellung, in der der Block aus magnetostriktivem Material im Verhältnis zur Gruppe von Dauermagneten verschoben ist.

## Claims

1. An electricity generator comprising:
- a converter (20) capable of converting a variation of a magnetic field into a potential difference between two electrical terminals, this converter comprising for this purpose:
* an electromechanical transducer (50) capable of directly transforming a mechanical deformation exerted on this electromechanical transducer into a potential difference between the two electrical terminals, and
* a magnetostrictive layer (52) extending mainly parallel to a reference plane and fixed with no degree of freedom to the electromechanical transducer, this magnetostrictive layer comprising at least one block (70-73) made of magnetostrictive material capable of converting a variation of the magnetic field into a mechanical deformation exerted on the electromechanical transducer,
- a magnetic field source (4) comprising a group (90-93, 96-99; 130; 140; 160; 196-199, 202-205; 240) of several permanent magnets aligned along an axis of alignment, at least one of the group and of the converter being movable, alternately, between:
* a first position wherein the field lines of the group of permanent magnets pass through the same block made of magnetostrictive material and cause a first deformation of this block made of magnetostrictive material, and
* a second position wherein the block made of magnetostrictive material has a second deformation, different from the first deformation,
**characterised in that** the group (90-93, 96-99; 130; 140; 160; 196-199, 202-205; 240) of permanent magnets comprises a succession of first permanent magnets (112-115; 142-145) along the axis of alignment, a first permanent magnet being a permanent magnet of the group which has the two following characteristics:
- an aspect ratio, defined by the ratio of the thickness thereof over the length thereof in the direction of the magnetic moment thereof, of between 1/10 and ten, and
- the main part of the field lines which are looped by way of the block made of magnetostrictive material and of this first permanent magnet in the first position do not pass through another first permanent magnet,
these first permanent magnets being arranged against one another such that the magnetic field induces inside the block made of magnetostrictive material in the first position by any one of these first permanent magnets is parallel and in the opposite direction to the magnetic field induced at the same time in this same block by the first permanent magnet immediately consecutive along the axis of alignment.

2. Generator according to claim 1, wherein each first permanent magnet (112-115) has a magnetic moment parallel to the axis of alignment and in the opposite direction of the magnetic moment of the first permanent magnet immediately following in said succession of first permanent magnets.

3. Generator according to claim 2, wherein the group also comprises at least one second permanent magnet (118-122) placed immediately to the side of one of the first permanent magnets (112-115), the magnetic moment of this second permanent magnet being perpendicular to the reference plane and the direction thereof being the same as that of the field lines which pass through the block made of magnetostrictive material and the first permanent magnet to the side of which it is immediately placed.

4. Generator according to claim 3, wherein the length of the second permanent magnet (118-122) in the direction of the magnetic moment thereof is greater than or equal to the thickness, in the direction perpendicular to the reference plane, of the first permanent magnet to the side of which it is immediately placed, and the thickness of the second permanent magnet in a direction parallel to the axis of alignment is at least twice as small as the length of the first permanent magnet to the side of which it is immediately placed.

5. Generator according to claim 2, wherein the magnetic field source comprises at least one magnetic tooth (132-136), made of soft magnetic material, directly placed to the side of one of the first permanent magnets in the direction of the axis of alignment.

6. Generator according to any one of the preceding claims, wherein the amplitude of the vectorial sum of the magnetic moments of the group (90-93, 96-99; 130; 140; 160; 196-199, 202-205; 240) of permanent magnets is equal to zero to within plus or minus ε, where ε is equal to 10% of the sum of the amplitudes of the magnetic moments of the permanent magnets of the group.

7. Generator according to any one of the preceding claims, wherein the magnetic field source comprises a second group of permanent magnets, symmetrical to the first group of permanent magnets with respect to a plane parallel to the reference plane and passing halfway up the block made of magnetostrictive material.

8. Generator according to any one of claims 1 to 6, wherein the converter is located on one side of the group of permanent magnets and the generator (250) comprises another converter (252) placed on the opposite side with respect to this group of permanent magnets, these two converters being symmetrical to one another with respect to a median plane of the group of permanent magnets containing the axis of alignment of this group.

9. Generator according to any one of claims 1 to 6, wherein the converter is located on one side of the group of permanent magnets and the generator comprises a plate (262) made of magnetically soft material placed on the opposite side, with respect to this group of permanent magnets.

10. Generator according to any one of the preceding claims, wherein the aspect ratio of the first permanent magnets is greater than or equal to 0.2 or 0.5 and less than or equal to 5 or 2.

11. Generator according to any one of the preceding claims, wherein the permanent magnets of the group are fixed with no degree of freedom to one another and at least one of the group and of the converter is moveable alternately, between:
- the first position wherein the block made of magnetostrictive material is opposite the group of permanent magnets, and
- the second position wherein the block made of magnetostrictive material is offset with respect to the group of permanent magnets.
